# EUROPEAN PATENT SPECIFICATION

(11) **EP 3 893 400 B1**
(45) Date of publication and mention of the grant of the patent: **04.11.2026**
(21) Application number: 19894383.9
(22) Date of filing: 05.12.2019
(51) Int. Cl.: H03M 13/13

(54) **SORTING METHOD AND APPARATUS, AND ELECTRONIC DEVICE AND MEDIUM**
VERFAHREN UND VORRICHTUNG ZUR SORTIERUNG SOWIE ELEKTRONISCHE VORRICHTUNG UND MEDIUM
PROCÉDÉ ET APPAREIL DE TRI, DISPOSITIF ÉLECTRONIQUE ET SUPPORT

(30) Priority: 05.12.2018 CN 201811483150
(43) Date of publication of application: 13.10.2021
(73) Proprietor: Sanechips Technology Co., Ltd., Shenzhen, Guangdong 518055 (CN)
(72) Inventor: SHI, Guangming, Shenzhen, Guangdong 518057 (CN)
(74) Representative: Canzler & Bergmeier Patentanwälte Partnerschaft mbB
(86) International application number: PCT/CN2019/123423
(87) International publication number: WO 2020/114469

(56) References cited:
- CN-A- 1 434 594
- CN-A- 101 667 840
- CN-A- 101 997 553
- CN-A- 106 803 759
- KR-A- 20000 052 143
- BALATSOUKAS-STIMMING ALEXIOS ET AL: "LLR-Based Successive Cancellation List Decoding of Polar Codes", vol. 63, no. 19, 1 October 2015 (2015-10-01), pages 5165 - 5179, XP011667871, ISSN: 1053-587X, Retrieved from the Internet <URL:https://ieeexplore.ieee.org/abstract/document/7114328> [retrieved on 20150901], DOI: 10.1109/TSP.2015.2439211
- CHENYANG XIA ET AL: "A High-Throughput Architecture of List Successive Cancellation Polar Codes Decoder with Large List Size", ARXIV.ORG, CORNELL UNIVERSITY LIBRARY, 201 OLIN LIBRARY CORNELL UNIVERSITY ITHACA, NY 14853, 8 May 2018 (2018-05-08), XP081138865, DOI: 10.1109/TSP.2018.2838554
- YUAN BO ET AL: "Low-Latency Successive-Cancellation List Decoders for Polar Codes With Multibit Decision", IEEE TRANSACTIONS ON VERY LARGE SCALE INTEGRATION (VLSI) SYSTEMS, IEEE SERVICE CENTER, PISCATAWAY, NJ, USA, vol. 23, no. 10, 1 October 2015 (2015-10-01), pages 2268 - 2280, XP011670019, ISSN: 1063-8210, [retrieved on 20150923], DOI: 10.1109/TVLSI.2014.2359793
- HAN JIANGXUE ET AL: "Simplified multi-bit SC list decoding for polar codes", PROC. 2016 IEEE INTERNATIONAL CONFERENCE ON ACOUSTICS, SPEECH AND SIGNAL PROCESSING (ICASSP), IEEE, 20 March 2016 (2016-03-20), pages 996 - 1000, XP032900751, DOI: 10.1109/ICASSP.2016.7471825
- ALEXIOS BALATSOUKAS-STIMMING ET AL: "On metric sorting for successive cancellation list decoding of polar codes", PROC. 2015 IEEE INTERNATIONAL SYMPOSIUM ON CIRCUITS AND SYSTEMS (ISCAS), 27 January 2015 (2015-01-27), pages 1 - 4, XP055330298, ISBN: 978-1-4799-8391-9, DOI: 10.1109/ISCAS.2015.7169066
- SONG HAOCHUAN ET AL: "Efficient metric sorting schemes for successive cancellation list decoding of polar codes", PROC. 2017 IEEE INTERNATIONAL SYMPOSIUM ON CIRCUITS AND SYSTEMS (ISCAS), IEEE, 28 May 2017 (2017-05-28), pages 1 - 4, XP033156521, DOI: 10.1109/ISCAS.2017.8050906
- HUAN LI ET AL: "Hybrid Sorting Method for Successive Cancellation List Decoding of Polar Codes", COMMUNICATION AND NETWORK SECURITY, ACM, 2 PENN PLAZA, SUITE 701NEW YORK, NY10121-0701USA, 24 November 2017 (2017-11-24), pages 23 - 26, XP058386863, ISBN: 978-1-4503-5349-6, DOI: 10.1145/3163058.3163079

## Description

### Technical Field

The present disclosure relates to the field of communications, and in particular, to a sorting method and apparatus, an electronic device and a computer readable storage medium.

### Background

During decoding of a polar code, a successive cancellation list (SCL) algorithm is generally used. During decoding, the SCL algorithm maintains at most L paths simultaneously, and measures each path, so as to improve the decoding performance. The number L of survivor paths is an integral power of 2, and the increase of L can improve the performance of a decoder, but also can bring increase of the decoding complexity.

Before decoding the polar code, the decoding sequence needs to be determined first according to a decoding tree. In the decoding process, a decoder correspondingly updates a logarithm likelihood rate (LLR) and a path metric (PM) value according to the position of the current node in the decoding tree. In a case where an information bit is involved, a decoding path corresponding to the current information bit is split into two paths. In a case where the total number of paths extended currently is greater than L, a sorting algorithm is started, and L paths with the minimum PM values are selected. After iteration of 2N0-2 (N0 is the code length of a mother code) nodes except a root node is completed, the decoding process ends, and the decoding result is outputted according to a certain rule.

During each decoding, in a case where the number of extended paths is greater than the number L of the survivor paths, L survivor paths with the minimum PM values need to be selected by sorting. The quality of sorting performance directly affects the decoding performance. The current SCL decoder has a long time delay in a sorting operation, and occupies a large hardware resource, resulting in low sorting performance, high power consumption and poor flexibility.

Following prior art documents relate to hardware implementations of the SCL algorithm: Balatsoukas-Stimming Alexios et al.: "LLR-Based Successive Cancellation List Decoding of Polar Codes", IEEE Trans. Signal Processing, vol.63, no.19, 1st October 2015 (2015-10-01), pages 5165-5179, DOI: 10.1109/TSP.2015.2439211

Chenyang Xia et al.: "A High-Throughput Architecture of List Successive Cancellation Polar Codes Decoder with Large List Size", arXiv.org, Cornell University Ithaca, NY, 14853, 8 May 2018 (2018-05-08), DOI: 10.1109/TSP.2018.2838554

Yuan Bo et al.: "Low-Latency Successive-Cancellation List Decoders for Polar Codes with Multibit Decision", IEEE Trans. VLSI Systems, vol.23, no.10, 1 October 2015 (2015-10-01), pages 2268-2280, DOI: 10.1109/TVLSI.2014.2359793

Han Jiangxue et al.: "Simplified multi-bit SC list decoding for polar codes", 2016 IEEE International Conference on Acoustics, Speech and Signal Processing (ICASSP), 20 March 2016 (2016-03-20), pages 996-1000, DOI: 10.1109/ICASSP.2016.7471825 Balatsoukas-Stimming et al.: "On metric sorting for successive cancellation list decoding of polar codes", 2015 IEEE International Symposium on Circuits and Systems (ISCAS), 27 January 2015 (2015-01-27), pages 1-4, DOI: 10.1109/ISCAS.2015.7169066

Song Haochuan et al.: "Efficient metric sorting schemes for successive cancellation list decoding of polar codes", 2017 IEEE International Symposium on Circuits and Systems (ISCAS), 28 May 2017 (2017-05-28), pages 1-4, DOI: 10.1109/ISCAS.2017.8050906

Huan Li et al.: "Hybrid Sorting Method for Successive Cancellation List Decoding of Polar Codes", Communication and Network Security, ACM, 24 November 2017 (2017-11-24), pages 23-26, DOI: 10.1145/3163058.3163079

### Summary

Embodiments of the present disclosure provide a sorting method and apparatus, an electronic device, and a computer readable storage medium, which can overcome the problems in the related art such as a long decoding time delay, a large hardware resource consumption, and poor flexibility in the decoding of a polar code.

Some embodiments of the present disclosure provide a sorting method, the method including:
acquiring configuration information, wherein the configuration information includes the number L of survivor paths, the length NO of a mother code, at least one path deletion instruction and a truncation bit width W;
performing truncation processing on each of multiple pieces of inputted data according to the truncation bit width W, and storing, in a memory, each piece of truncated low-bit information of the data subjected to the truncation processing;
performing, according to the at least one path deletion indication, data extraction on the multiple pieces of data from which the low-bit information is truncated, and recording bit sequences of the extracted data;
compactly arranging the extracted data, and determining the number of data obtained after the extracted data is compactly arranged; and
determining L pieces of to-be-outputted data based on the number L of the survivor paths, the length NO of the mother code, the extracted data, the bit sequences of the extracted data and the number of the data obtained after the extracted data is compactly arranged.

Some embodiments of the present disclosure provide a sorting apparatus, the apparatus including:
an acquisition module, configured to acquire configuration information, wherein the configuration information includes the number L of survivor paths, the length NO of a mother code, at least one path deletion instruction and a truncation bit width W;
a truncation module, configured to perform truncation processing on each of multiple pieces of inputted data according to the truncation bit width W, and store, in a memory, each piece of truncated low-bit information of the data subjected to the truncation processing;
an extraction module, configured to perform, according to the at least one path deletion indication, data extraction on the multiple pieces of data from which the low-bit information is truncated, and record bit sequences of the extracted data, and compactly arrange the extracted data, and determine the number of data obtained after the extracted data is compactly arranged; and
an output control module, configured to determine L pieces of to-be-outputted data based on the number L of the survivor paths, the length NO of the mother code, the extracted data, the bit sequences of the extracted data and the number of the data obtained after the extracted data is compactly arranged.

Some embodiments of the present disclosure further provide an electronic device, including: at least one processor; and a memory, configured to store at least one computer program, wherein when the at least one computer program is executed by the at least one processor, the at least one processor is enabled to implement the sorting method according to some embodiments of the present disclosure.

Some embodiments of the present disclosure further provide a computer readable storage medium, the computer readable storage medium stores computer executable instructions, and the computer executable instructions are used for executing the sorting method according to the embodiments of the present disclosure.

By means of the technical solutions provided in the embodiments of the present disclosure, the problems of a long decoding time delay, a large hardware resource consumption, poor flexibility, etc. existing in a polar code decoding process in the related art can be overcome.

### Brief Description of the Drawings

Fig. 1 is a schematic flowchart of a sorting method according to some embodiments of the present disclosure;
Fig. 2 is a schematic diagram of a conventional bitonic sorting principle according to some embodiments of the present disclosure;
Fig. 3 is a schematic diagram of bmN basic units according to some embodiments of the present disclosure;
Fig. 4 is a schematic diagram of a 64-input/output fully-sorted bm array according to some embodiments of the present disclosure;
Fig. 5 is a schematic diagram of a composition structure of a sorting apparatus according to some embodiments of the present disclosure;
Fig. 6 is a schematic diagram of system architecture of a sorting system according to some embodiments of the present disclosure;
Fig. 7 is a schematic diagram of a sorting bm array supporting NO=512 and L=32 according to some embodiments of the present disclosure; and
Fig. 8 is a schematic diagram of a structure of an electronic device according to some embodiments of the present disclosure.

### Detailed Description of the Embodiments

In order to understand the features and technical content of the embodiments of the present disclosure more comprehensive, hereinafter, the implementation of the embodiments of the present disclosure is described in detail with reference to the accompanying drawings, wherein the accompanying drawings are only used for reference and illustration and are not intended to limit the embodiments of the present disclosure.

### Embodiment I

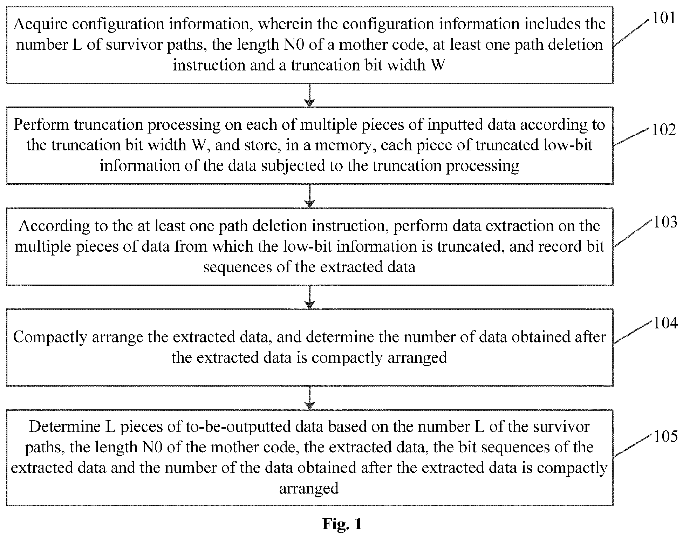

Fig. 1 is a schematic flowchart of a sorting method according to some embodiments of the present disclosure; the sorting method is applied to a decoding process of a polar code. As shown in Fig. 1, the method includes operations 101 to 105.

In operation 101, configuration information is acquired, wherein the configuration information includes the number L of survivor paths, the length NO of a mother code, at least one path deletion instruction and a truncation bit width W.

In the present embodiment, the configuration information may be preset according to decoding requirements of the polar code.

In operation 102, truncation processing is performed on each of multiple pieces of inputted data according to the truncation bit width W, and each piece of truncated low-bit information of the data subjected to the truncation processing is stored in a memory.

That is to say, for each piece of data inputted, one or more low-bits (the low-bit information) of the data are truncated according to the truncation bit width W in the configuration information, and the low-bit data is stored in the memory.

The truncation mode for performing truncation processing on the inputted data according to the truncation bit width W is described as follows.

It is assumed that the inputted data is a[N:0], then data outputted after truncation is a[N:W], and the truncated data a[W-1:0] is stored in the memory.

Thus, high-bit information obtained by the truncation processing will be the input data of operation 103.

In operation 103, according to the at least one path deletion instruction, data extraction is performed on the multiple pieces of data from which the low-bit information is truncated, and bit sequences of the extracted data are recorded.

In some embodiments, the operation that, according to the at least one path deletion instruction, data extraction is performed on the multiple pieces of data from which the low-bit information is truncated may be implemented in the following manner.
data in the multiple pieces of data from which the low-bit information is truncated is correspondingly extracted according to an extraction rule and the path deletion instruction of each of the survivor paths, wherein the extraction rule is to reserve data corresponding to all information bits.

For example, currently, there are two survivor paths, and the extraction rule is to reserve data corresponding to all information bits. The data format of the first survivor path before extraction is {info0, null, info1, null, info2, null, info3, null}, wherein the path deletion instruction herein indicates that info0 to info3 are data corresponding to information bits, and null refers to data corresponding to a non-information bit, and thus the arrangement of the data after extraction is {info0, info1, info2, info3}. The data format of the second survivor path before extraction is {info6, null, info7, null, info8, null, info9, null}, and thus the arrangement of the data after extraction is {info6, info7, info8, info9}. Then, the data extracted from the two survivor paths is compactly arranged to obtain {info0, info1, info2, info3, info6, info7, info8, info9}.

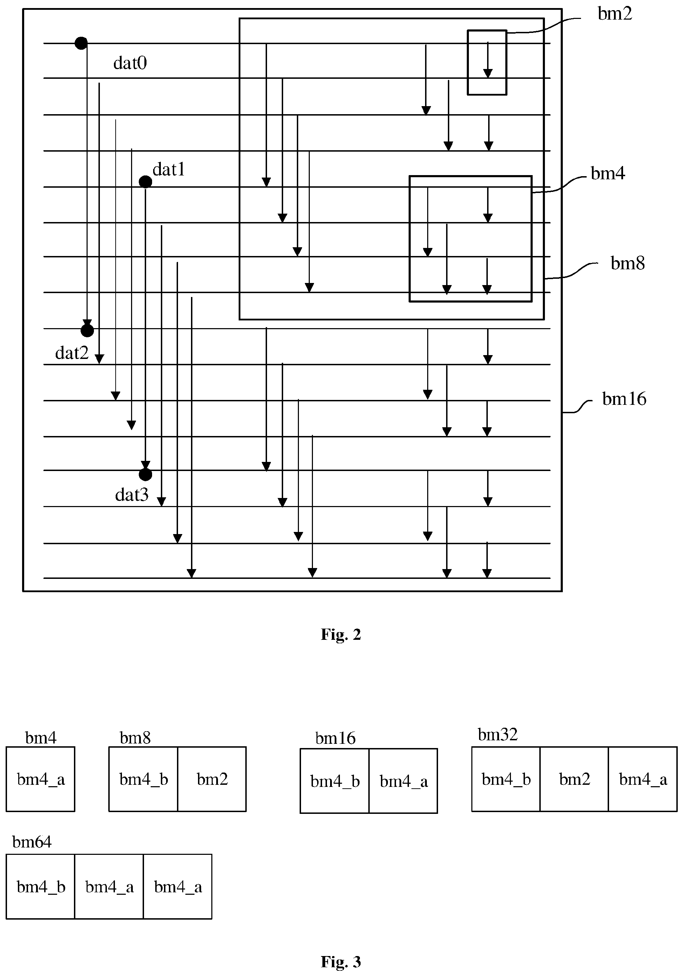

In some embodiments, all input data received in operation 103 is first numbered in an ascending order, and the number is used to record the bit sequence of each piece of data. Data is extracted according to the path deletion instruction in the configuration information, and the bit sequences of the extracted data are recorded and are sent together to a subsequent processing module, such as a bitonic sorting bmN array, or an output control module. Taking 4b-SCL as an example, in each survivor path, 4 bits are decoded in each decoding process, a maximum of 16 paths are extended, and which bit in the 4 bits requires extension needs to be provided. The format of the path deletion instruction is {info_fig0, info_flg1, info_flg2, info_flg3}. For example, it is assumed that info_flg0 and info_flg2 are 1, which indicates that paths corresponding to the two bits need to be extended, that is, values of the two bits may be 0 and 1; and in a case where info_flg1 and info_flg2 are 0, which indicates that paths corresponding to the two bits are not extended, that is, values of the two bits can only be 0. In the present example, the numbers of the reserved data paths are 4'b0000, 4'b0010, 4'b1000 and 4'b1010, that is, data corresponding to paths 0, 2, 8 and 10 is extracted.

In operation 104, the extracted data is compactly arranged, and the number of data obtained after the extracted data is compactly arranged is determined.

In this way, it is convenient to select, according to the number of the data obtained after the extracted data is compactly arranged, a manner for determining the L pieces of to-be-outputted data in operation 105.

It should be noted that in the extraction process, the bit sequence of each piece of data is also recorded. For example, in {info0, null, info1, null, info2, null, info3, null}, the bit sequence corresponding to info0 is 0, the bit sequence corresponding to the first null is 1, the bit sequence corresponding to info1 is 2, the bit sequence corresponding to the second null is 3, the bit sequence corresponding to info2 is 4, the bit sequence corresponding to the third null is 5, the bit sequence corresponding to info3 is 6, and the bit sequence corresponding to the fourth null is 7. The data after extraction is arranged as {info0, info1, info2, info3}, and the corresponding bit sequences are recorded as {0, 2, 4, 6}.

In operation 105, L pieces of to-be-outputted data are determined based on the number L of the survivor paths, the length NO of the mother code, the extracted data, the bit sequences of the extracted data and the number of the data obtained after the extracted data is compactly arranged.

In some embodiments, the operation that the L pieces of to-be-outputted data are determined based on the number L of the survivor paths, the length NO of the mother code, the extracted data, the bit sequences of the extracted data and the number of the data obtained after the extracted data is compactly arranged may be implemented in the following manner.

In a case where the number of the data obtained after the extracted data is compactly arranged is greater than L, bitonic sorting is performed, by using a preset array, on the data obtained after the extracted data is compactly arranged, and L pieces of data are extracted from the data obtained after the extracted data is compactly arranged.

In a case where the number of the data obtained after the extracted data is compactly arranged is less than or equal to L, the data obtained after the extracted data is compactly arranged is complemented to L pieces of data.

Here, the preset array may be a bmN array (basic sorting unit).

In some embodiments, the operation that the L pieces of data are extracted from the data obtained after the extracted data is compactly arranged includes the following operations.

L pieces of minimum data are selected from the data obtained after the extracted data is compactly arranged, and the bit sequence corresponding to each piece of data in the L pieces of data is determined.

Here, the bit sequence is consistent with the bit sequence provided when performing numbering in the process of data extraction in operation 103.

In the present embodiment, it is supported that L pieces of data are selected from any NO pieces of data, and the value of NO includes, but is not limited to, 32, 64, 128, 256, or 512. The value of L includes, but is not limited to, 8, 16 or 32.

In this way, L pieces of data are extracted from the bmN array according to the number L of the survivor paths, the length NO of the mother code, and the number of valid data. Herein, the number of valid data can be understood as the number of the data obtained after the extracted data is compactly arranged.

Fig. 2 shows a basic principle diagram of conventional bitonic sorting. Herein, bmN is able to sort N pieces of inputted data and output an ordered sequence of the N pieces of inputted data. For example, bm4 is able to sort 4 pieces of data and output an ordered sequence of the 4 pieces of data. In some embodiments of the present disclosure, bm4 is improved and optimized. As shown in Fig. 2, bm16 has a total of 4 stages of comparisons from left to right. The first two stages of comparisons can be combined into one stage of bm4_b under the premise that the data is extracted at intervals. For example, data at positions shown by black points in Fig. 2 include four pieces of data sent to one bm4_b, and only the four pieces of data extracted at intervals can be combined into one bm4_b. The following 2 stages of comparisons may be achieved by using a conventional bm4, which is denoted as bm4_a. The method of pairwise comparison while determination is used to complete the total sorting. By means of the described optimization, the original 4 stages of bm2 comparison logics of bm16 can be reduced to 2 stages of bm4 comparison logics.

In Fig. 2, the four pieces of data represented by black points follow a certain rule, since a previous stage of input thereof is a bitonic sequence and thus there must be dat1 >= dat0 & dat2 >= dat3. Based on this fact, six comparators in the original bm4_a can be reduced to four. In addition, the maximum value of bm4_b can only be da1 or dat2, the minimum value of bm4_b can only be dat0 or dat3, and the second minimum value or the second maximum value of bm4_b can only be dat0 or dat3. According to this rule, bm4_b can achieve total sorting of four pieces of data by using a few logic.

Based on the described principle, Fig. 3 lists optimized basic sorting units bmN.
bm4: consisting of bm4_a;
bm8: consisting of bm4_b and bm2 in cascade;
bm16: consisting of bm4_b and bm4_a in cascade;
bm32: consisting of bm4_b, bm2 and bm4_a in cascade; and
bm64: consisting of bm4_b, bm4_a and bm4_a in cascade.

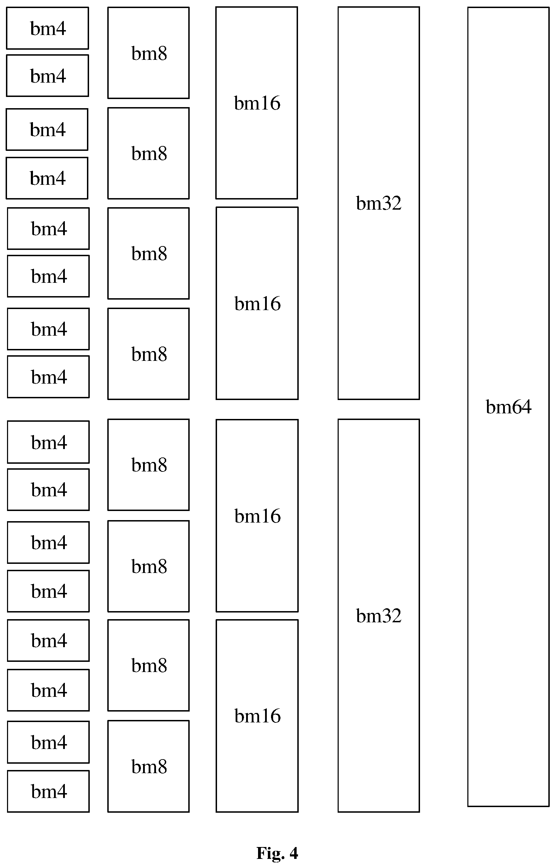

Fig. 4 lists a sorting array required for total sorting of 64 pieces of data. When N0=32, L=8 or 16, in a case where 8 or 16 pieces of minimum data is extracted from the output data of a first stage of bm4_b array in the bm32 unit, the requirements of polar code decoding can be satisfied. When N0=64, L=16 or 32, in a case where 16 or 32 minimum pieces of data is extracted from the output data of a first stage of bm4_b array in the bm64 unit, the requirements of polar code decoding can be satisfied. According to the same principle, in a case where two stages of bm64, one stage of bm2, and one stage of bm4 are connected in cascade following bm64, a set of array can be used to achieve the sorting operation of selecting L from N0=32, 64, 128, 256, 512.

In some embodiments, the operation that the data obtained after the extracted data is compactly arranged is complemented to the L pieces of data may be implemented in the following manner.

The number and values of complementing data are determined, wherein the value of each piece of complementing data is a maximum value which is able to be represented by a bit width of the current data.

For example, in a case where it is determined that the number of the complementing data is X, then the values of the X pieces of complementing data are consistent.

In this way, in a case where the number of the data obtained after the extracted data is compactly arranged is L-X, the L-X pieces of data obtained after the extracted data is compactly arranged are complemented, and then the X pieces of complementing data and the values of the X pieces of complementing data are determined.

In the embodiments of the present disclosure, after determining the L pieces of to-be-outputted data, the method may further include the following operations.

In a case where the number of the data obtained after the extracted data is compactly arranged is greater than L, corresponding truncated low-bit information is extracted from the memory according to information of the bit sequences of the extracted L pieces of data, and the extracted L pieces of data and the extracted low-bit information are spliced into original data.

In a case where the number of the data obtained after the extracted data is compactly arranged is less than or equal to L, corresponding truncated low-bit information is extracted from the memory according to information of the bit sequences corresponding to the data obtained after the extracted data is compactly arranged, and the data obtained after the extracted data is compactly arranged and the extracted low-bit information are spliced into original data.

In this way, L pieces of data can be first extracted from the bmN array, and then a bit-complementing processing is performed on the L pieces of data.

For example, the bit sequence information recorded in the process of compact arrangement and sorting of data is used, the truncated low-bit information is extracted from the memory in operation 102, and is spliced into original data and outputted. For example, the splicing manner is {a[N:W], a[W-1:0]}, that is, the output data is a[N:0].

By means of the technical solutions provided in the embodiments of the present disclosure, compared with the related art, sorting functions required by polar code decoding can be completed with fewer hardware resources, facilitating high-speed circuit design. By means of a multi-tap bmN array, a set of circuits can be used to support the sorting requirements for decoding of a polar code of each code length.

### Embodiment II

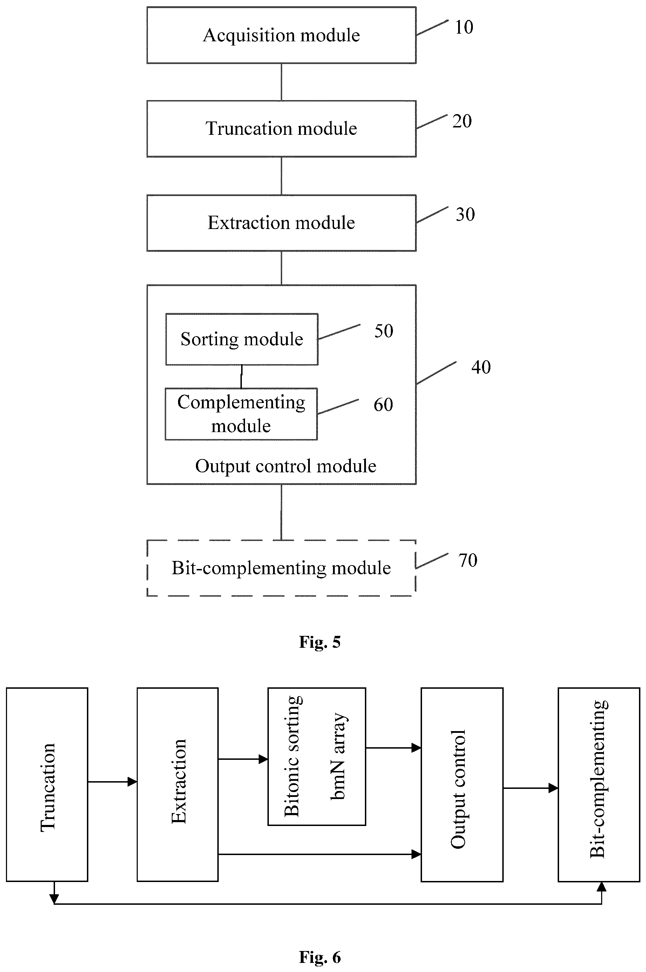

Fig. 5 is a schematic diagram of a composition structure of a sorting apparatus according to some embodiments of the present disclosure. As shown in Fig. 5, the sorting apparatus includes: an acquisition module 10, a truncation module 20, an extraction module 30 and an output control module 40.

The acquisition module 10 is configured to acquire configuration information, wherein the configuration information includes the number L of survivor paths, the length NO of a mother code, at least one path deletion instruction and a truncation bit width W.

The truncation module 20 is configured to perform truncation processing on each of multiple pieces of inputted data according to the truncation bit width W, and store, in a memory, each piece of truncated low-bit information of the data subjected to the truncation processing.

The extraction module 30 is configured to perform, according to the at least one path deletion indication, data extraction on the multiple pieces of data from which the low-bit information is truncated, record bit sequences of the extracted data, compactly arrange the extracted data, and determine the number of data obtained after the extracted data is compactly arranged.

The output control module 40 is configured to determine L pieces of to-be-outputted data based on the number L of the survivor paths, the length NO of the mother code, the extracted data, the bit sequences of the extracted data and the number of the data obtained after the extracted data is compactly arranged.

As some embodiments, the output control module 40 may include:
a sorting module 50, configured to, in a case where the number of the data obtained after the extracted data is compactly arranged is greater than L, perform, by using a preset array, bitonic sorting on the data obtained after the extracted data is compactly arranged by the extraction module 30, and extract L pieces of data from the data obtained after the extracted data is compactly arranged; and
a complementing module 60, configured to, in a case where the number of the data obtained after the extracted data is compactly arranged by the extraction module 30 is less than or equal to L, complement the data obtained after the extracted data is compactly arranged to L pieces of data.

In some embodiments, the sorting module 50 is configured to select L pieces of minimum data from the data obtained after the extracted data is compactly arranged, and determine the bit sequence corresponding to each piece of data in the L pieces of data.

In some embodiments, the complementing module 60 is configured to determine the number and values of complementing data, wherein the value of each piece of complementing data is a maximum value which is able to be represented by a bit width of the current data.

In some embodiments, the apparatus further includes a bit-complementing module 70, the bit-complementing module 70 being configured to:
in a case where the number of the data obtained after the extracted data is compactly arranged is greater than L, extract corresponding truncated low-bit information from the memory according to information of the bit sequences of the extracted L pieces of data, and splice the extracted L pieces of data and the extracted low-bit information into original data; and
in a case where the number of the data obtained after the extracted data is compactly arranged is less than or equal to L, extract corresponding truncated low-bit information from the memory according to information of the bit sequences corresponding to the data obtained after the extracted data is compactly arranged, and splice the data obtained after the extracted data is compactly arranged and the extracted low-bit information into original data.

In some embodiments, the extraction module 30 is configured to correspondingly extract, according to an extraction rule and the path deletion instruction of each of the survivor paths, data in the multiple pieces of data from which the low-bit information is truncated, wherein the extraction rule is to reserve data corresponding to all information bits.

In practical applications, the acquisition module 10, the truncation module 20, the extraction module 30, the output control module 40, the sorting module 50, the complementing module 60 and the bit-complementing module 70 may all be implemented by a central processing unit (CPU), a microprocessor unit (MPU), a digital signal processor (DSP), or a field-programmable gate array (FPGA) located in the sorting apparatus.

In the sorting apparatus in the present embodiment, sorting functions required by polar code decoding can be completed with fewer hardware resources, facilitating high-speed circuit design. By means of a multi-tap bmN array, a set of circuits can be used to support the sorting requirements for decoding of a polar code of each code length.

### Embodiment III

Fig. 6 shows a schematic diagram of system architecture of a sorting system. As shown in Fig. 6, the architecture mainly includes several parts such as truncating, extracting, bitonic sorting bmN array, output control, and bit-complementing.
(1) Truncation:
   Low bits of inputted data are truncated according to configuration information, the low-bit data is stored in a memory, and the truncated data is outputted to an extraction module. For example, it is assumed that the inputted data is a[N:0], then data outputted after truncation is a[N:W], and the truncated data a[W-1:0] is stored in the memory.
   The described truncation processing can be achieved by a truncation module.
(2) Extraction:
   All input data is first numbered in an ascending order, and the number is used to record the bit sequence of each piece of data. Then, data is extracted according to the path deletion instruction in the configuration information, and the bit sequences of the extracted data are recorded and are sent together to a subsequent bitonic sorting bmN array, or an output control module. Taking 4b-SCL as an example, in each survivor path, 4 bits are decoded in each decoding process, a maximum of 16 paths are extended, and which bit in the 4 bits requires extension needs to be provided. The format of the path deletion instruction is {info_fig0, info_flg1, info_flg2, info_flg3}. For example, it is assumed that info_flg0 and info_flg2 are 1, which indicates that paths corresponding to the two bits need to be extended, that is, values of the two bits may be 0 and 1; and in a case where info_flg1 and info_flg2 are 0, which indicates that paths corresponding to the two bits are not extended, that is, values of the two bits can only be 0. In the present example, the numbers of the reserved data paths are 4'b0000, 4'b0010, 4'b1000 and 4'b1010, that is, data corresponding to paths 0, 2, 8 and 10 is extracted.
   The described extraction process can be achieved by an extraction module.
(3) Bitonic sorting bmN array:
   The input data is sorted, and L pieces of minimum data and the bit sequence corresponding to each piece of data are selected. It is supported that L pieces of data are selected from any NO pieces of data, and the value of NO includes, but is not limited to, 32, 64, 128, 256, or 512. The value of L includes, but is not limited to, 8, 16 or 32.

Fig. 2 shows a basic principle diagram of conventional bitonic sorting. Herein, bmN is able to sort N pieces of inputted data and output an ordered sequence of the N pieces of inputted data. For example, bm4 is able to sort 4 pieces of data and output an ordered sequence of the 4 pieces of data. In some embodiments of the present disclosure, bm4 is improved and optimized. As shown in Fig. 2, bm16 has a total of 4 stages of comparisons from left to right. The first two stages of comparisons can be combined into one stage of bm4_b under the premise that the data is extracted at intervals. For example, data at positions shown by black points in Fig. 2 include four pieces of data sent to one bm4_b, and only the four pieces of data extracted at intervals can be combined into one bm4_b. The following 2 stages of comparisons may be achieved by using a conventional bm4, which is denoted as bm4_a. The method of pairwise comparison while determination is used to complete the total sorting. By means of the described optimization, the original 4 stages of bm2 comparison logics of bm16 can be reduced to 2 stages of bm4 comparison logics.

In Fig. 2, the four pieces of data represented by black points follow a certain rule, since a previous stage of input thereof is a bitonic sequence and thus there must be dat1 >= dat0 & dat2 >= dat3. Based on this fact, six comparators in the original bm4_a can be reduced to four. In addition, the maximum value of bm4_b can only be dat1 or dat2, the minimum value of bm4_b can only be dat0 or dat3, and the second minimum value or the second maximum value of bm4_b can only be dat0 or dat3. According to this rule, bm4_b can achieve total sorting of four pieces of data by using a few logic.

Based on the described principle, Fig. 3 lists optimized basic sorting units bmN.
bm4: consisting of bm4_a;
bm8: consisting of bm4_b and bm2 in cascade;
bm16: consisting of bm4_b and bm4_a in cascade;
bm32: consisting of bm4_b, bm2 and bm4_a in cascade; and
bm64: consisting of bm4_b, bm4_a and bm4_a in cascade; and

Fig. 4 lists a sorting array required for total sorting of 64 pieces of data. When N0=32, L=8 or 16, in a case where 8 or 16 pieces of minimum data is extracted from the output data of a first stage of bm4_b array in the bm32 unit, the requirements of polar code decoding can be satisfied. When N0=64, L=16 or 32, in a case where 16 or 32 minimum pieces of data is extracted from the output data of a first stage of bm4_b array in the bm64 unit, the requirements of polar code decoding can be satisfied. According to the same principle, in a case where two stages of bm64, one stage of bm2, and one stage of bm4 are connected in cascade following bm64, a set of array can be used to achieve the sorting operation of selecting L from N0=32, 64, 128, 256, 512.

The described bitonic sorting bmN array can be achieved by a sorting module.

### (4) Output control:

According to L and NO in the configuration information and control information inputted by the extraction module, L pieces of data are selected from the data outputted by the bitonic sorting bmN array or the data outputted by the extraction module and outputted.

The control information inputted by the extraction module includes the extracted data and bit sequences corresponding to the extracted data, and the number of data obtained after compact arrangement processing by the extraction module.

The described output control processing can be achieved by an output control module.

### (5) Bit-complementing:

The selected bit sequence information of the L pieces of data is used to extract the truncated low-bit information from the memory of the truncation module, and the data is complemented and then outputted.

The described bit-complementing processing may be achieved by a bit-complementing module.

It should be noted that the described system architecture is merely exemplary, and the present disclosure does not limit the architecture of the sorting system.

### Embodiment IV

Hereinafter, a 4b-SCL decoding algorithm in which NO=512 and L=32 is taken as an example for detailed description.

In a 4b-SCL decoding algorithm, each iteration decodes 4-bit data, a maximum of 16 paths are extended for each survivor path in each iteration, and the survivor paths can be extended to a maximum of 512 paths.

First, the number L of survivor paths, the length NO of a mother code, at least one path deletion instruction and a truncation bit width W are configured, and then data is inputted to perform a sorting and selection operation.

The number of data inputted by a truncation module is 512, and the bit sequence number is 0 to 511. W low bits of each piece of data are truncated and then the data is outputted to an extraction module, and the truncated data is stored into a memory.

The extraction module performs grouped extraction on the received data according to each group of 16 pieces of data. The 16 pieces of data in each group have an independent path deletion instruction. For example, the format of the path deletion instruction is {info_flgO, info_fig1, info_flg2, info_flg3}, wherein info_flgN being 1 represents an information bit requiring path extension, and the value of the bit position may be 0/1; and info_flgN being 0 represents that path extension is not needed, and the value of the bit position can only be 0. Splicing of a data value obtained according to this rule with the group number is the bit sequence number of data to be reserved in the group. For example, in a first group {0, 0, 1, 0} which represents 2 in a decimal system and a group number of 0, data having a bit sequence of 2 is reserved; and in a second group {0, 0, 1, 0} which represents 2 in a decimal system and a group number of 1, data having a bit sequence of 18 is reserved. After data extraction of all the groups is completed, the spliced data is A={ extraction data of group 0, extraction data of group 1, ..., extraction data of group 31}, and the spliced bit sequences are B={data bit sequences of group 0, data bit sequences of group 1, ..., data bit sequences of group 31}. In a case where the number of data in A is less than or equal to 32, A and B are directly outputted to an output control module. In a case where the number of data in A is greater than 32, A and B are outputted to a bitonic sorting bmN array module for bitonic sorting.

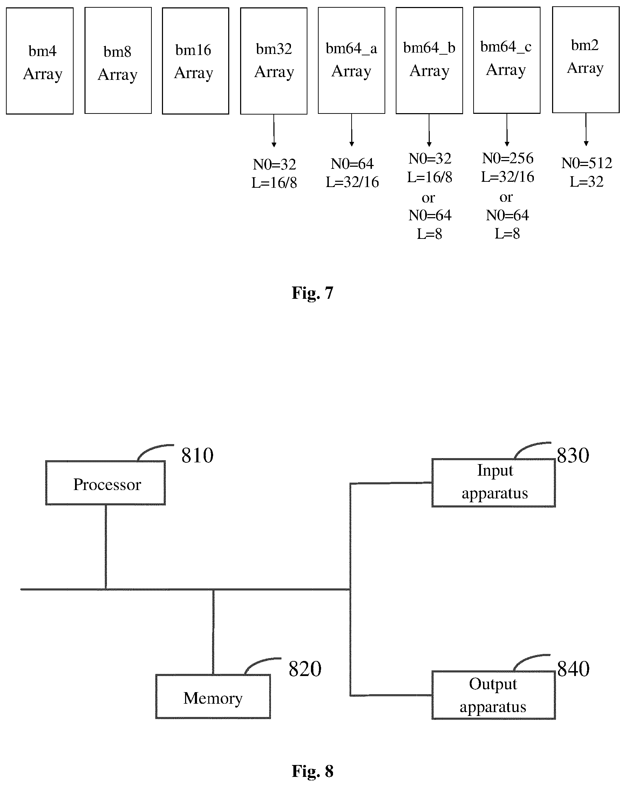

Fig. 7 shows a sorting bm array supporting NO=512 and L=32. The bm4 array consists of 128 bm4 sorting units in parallel, and after sorting, all data is sent to a bm8 array. The bm8 array consists of 64 bm8 sorting units in parallel, and after sorting, all data is sent to a bm16 array. The bm16 array consists of 32 bm16 sorting units in parallel, and after sorting, all data is sent to a bm32 array. The bm32 array consists of 16 bm32 sorting units in parallel, and after sorting, all data is sent to a bm64_a array. The bm64_a array consists of 8 bm64 sorting units in parallel, after sorting, 32 pieces of smaller data in the output result of each bm64 are selected, and a total of 256 pieces of data are sent to a bm64_b array. The bm64_b array consists of 4 bm64 sorting units in parallel, after sorting, 32 pieces of smaller data in the output result of each bm64 are selected, and a total of 128 pieces of data are sent to a bm64_c array. The bm64_c array consists of 2 bm64 sorting units in parallel, after sorting, 32 pieces of smaller data in the output result of each bm64 are selected, and a total of 64 pieces of data are sent to a bm2 array. The bm2 array consists of 32 bm2 sorting units, and the smaller 32 pieces of data are selected from 64 inputted data and outputted.

During the sorting and selection process, the bit sequence corresponding to each piece of data is also reserved and is sent together with the data to a lower-stage module.

As shown in Fig. 7, the sorting array supports input of 512 pieces of data, and selection of smaller 32 pieces of data, i.e., a requirement for decoding of polar codes in which NO=512 and L=32. In addition to the support on this requirement for decoding of polar codes, the following requirements for decoding of polar codes can also be supported via different taps: a requirement for decoding of polar codes in which N0=32 and L=16/8; a requirement for decoding of polar codes in which N0=64 and L=32/16/8; a requirement for decoding of polar codes in which NO=128 and L=32/16/8; and a requirement for decoding of polar codes in which of N0=256 and L=32/16. If connecting different bmNs in cascade following this sorting array, requirements for decoding of polar codes of any NO/L can be supported.

The output control module selects and outputs data of corresponding taps according to the number of valid data in A sent by the extraction module, and information of NO and L. In the present embodiment, in a case where the number of valid data in A is greater than 32, data in taps of NO=512 and L=32 is selected and outputted; and in a case where the number of valid data in A is less than or equal to 32, data sent by the extraction module is directly outputted to a bit-complementing module.

The bit-complementing module extracts truncated low-bit information of the data from the truncation module according to the received bit sequence information of each piece of data, complements the data and then outputs same.

### Embodiment V

The bitonic sorting bmN array module in Fig. 5 is separately extracted to perform a sorting and selection operation only, that is, L pieces of minimum or maximum data among M pieces of data are selected.

The structure of the sorting array is shown in Fig. 7. In a case where the number M of to-be-sorted data is not an integral power of 2, a maximum value which can be represented by bit widths of N0-M input data needs to be complemented after the to-be-sorted data. For example, in a case where the bit width of the input data is N, the complementing maximum value is 2N-1. Here, the calculation method of NO is:
the value of N0=2^{K}>M, wherein K is the minimum integer which satisfies this formula.

It is assumed that 32 pieces of minimum data is selected and outputted from 500 pieces of data (the bit width N of each piece of data is 8), the value of N0=2k>500, wherein K is the minimum integer which satisfies the formula, then K=9, N0=512, 12 pieces of data are complemented after the 500 pieces of data, and the values of the 12 pieces of data are all the maximum value 255 which can be represented by the bit width of the current data, and 512 pieces of data are obtained. The 512 pieces of data are inputted from the left side of the circuit of Fig. 7, and 32 pieces of minimum data can be obtained on the rightmost side.

In a case where 32 pieces of maximum data are to be selected from the described 500 pieces of data, first, 12 pieces of data are complemented after the 500 pieces of data, the values of the 12 pieces of data are the minimum value 0 which can be represented by the bit width of the current data, and after complementing to 512 pieces of data, the data is inputted from the left side of the circuit shown in Fig. 7. The structures of sorting circuits of bm4/bm8/bm16/bm32/bm64/bm2 are completely the same as the structure of the described sorting circuit for selecting a minimum value, and the mere difference lies in the selection of the output result after sorting by bm64 and the last stage of bm2. After the sorting of each bm64 is completed, 32 pieces of greater data in the output result are selected, and the last-stage bm2 array selects the 32 pieces of greater data from the inputted 64 pieces of data and outputs same, so that 32 pieces of maximum data can be selected from the 500 pieces of data.

Fig. 8 is a schematic diagram of hardware structure of an electronic device according to some embodiments. As shown in Fig. 8, the electronic device includes one or more processors 810 and a memory 820. In Fig. 8, one processor 810 is taken as an example.

The electronic device may further include: an input apparatus 830 and an output apparatus 840.

The processor 810, the memory 820, the input apparatus 830 and the output apparatus 840 in the electronic device can be connected by a bus or by other manners, and connection by a bus is taken as an example in Fig. 7.

The memory 820, as a computer readable storage medium, can be configured to store a software program, a computer executable program and a module. The processor 810 executes various function applications and data processing by running the software program, the instruction and the module which are stored in the memory 820, so as to implement any one method in the described embodiments.

The memory 820 may include a program storage region and a data storage region, wherein the program storage region may store an operating system and an application program required by at least one function; and the data storage region may store data created according to use of the electronic device, etc. In addition, the memory may include a volatile memory such as a random access memory (RAM), and may further include a non-volatile memory, for example, at least one magnetic disk storage device, a flash memory device, or other non-transient solid-state storage device.

The memory 820 may be a non-transitory computer readable storage medium or a transitory computer readable storage medium. The non-transitory computer readable storage medium is, for example, at least one magnetic disk storage device, a flash memory device, or other non-volatile solid-state storage device. In some embodiments, optionally, the memory 820 includes memories that is remotely located with respect to the processor 810, and these remote memories may be connected to the electronic device over a network. Examples of the described network may include the Internet, an intranet, a local area network, a mobile communication network, and a combination thereof.

The input apparatus 830 may be configured to receive inputted number or character information, and generate a key signal input related to user setting and function control of the electronic device. The output apparatus 840 can include a display device such as a display screen.

The present embodiment further provides a computer readable storage medium, the computer readable storage medium stores a computer program, and the computer program, after being executed by a processor, implements the described any one or more sorting methods.

The computer readable storage medium may be various types of storage media, and may preferably be a non-transitory computer readable storage medium in the present embodiment.

It should be understood by a person skilled in the art that for functions of programs in the computer readable storage medium in the present embodiment, they can be understood by referring to the related description of the sorting method in the embodiments.

By using the method according to the embodiments of the present disclosure, compared with the related art, sorting functions required by polar code decoding can be completed with fewer hardware resources, facilitating high-speed circuit design. By means of a multi-tap bmN array, a set of circuits can be used to support the sorting requirements for decoding of a polar code of each code length.

The technical solutions described in the embodiments of the present disclosure may be combined randomly without conflicts.

In the several embodiments provided in the present disclosure, it should be understood that the disclosed method and smart device may be implemented by other manners. The device embodiment described above is only illustrative. For example, the division of a unit is only division of logic functions and there can be other division methods in actual implementation, for example, multiple units or components can be combined or integrated into another system, or some features can be ignored or not executed. In addition, the coupling or direct coupling or communication connection between composition parts as shown or discussed may be indirect coupling or communication connection through some interfaces, modules or units, and may be electrical, mechanical connection or other forms of connection.

The units described as separate components may be or may not be physically separated, and components displayed as units may be or may not be physical units, that is, may be located in one position, or may be distributed on multiple network units. Some or all units can be selected according to actual needs, to achieve the purpose of the solutions of the embodiments.

In addition, the functional units in the embodiments of the present disclosure can be all integrated into a second processing unit, or each unit can be separately used as a unit, or two or more units can be integrated in one unit. The described integrated unit may be both implemented in the form of hardware, and may also be implemented in the form of hardware and software functional units.

## Claims

1. A sorting method, comprising:
acquiring (101) configuration information, wherein the configuration information comprises a number L of survivor paths, a length N0 of a mother code, at least one path deletion instruction and a truncation bit width W, wherein the number L corresponds to the maximum number of paths that a Successive Cancellation List, called SCL, decoding algorithm simultaneously maintains during decoding and the at least one path deletion instruction indicates which bits in a respective path correspond to information bits;
performing (102) truncation processing on each of multiple pieces of inputted data according to the truncation bit width W, wherein the inputted data is path metric, called PM, values of paths to be sorted, W lowest bits of each of the multiple pieces of inputted data are truncated from each piece of data to obtain low-bit information of the piece of data, and remaining data from which the W lowest bits have been truncated is high-bit information of the piece of data, and storing (102), in a memory, each piece of the low-bit information;
performing (103), according to the at least one path deletion instruction, data extraction on the multiple pieces of high-bit information, and recording (103) sequence numbers of the extracted data corresponding to the order of the data before data extraction, wherein the extracted data corresponds to all information bits of a respective path;
compactly arranging (104) the extracted data to obtain compactly arranged data, and determining the number of data comprised in the compactly arranged data, wherein the extracted data is concatenated to form the compactly arranged data, and the compactly arranged data is arranged in the same order of sequence numbers as the data before data extraction; and
determining (105) L pieces of to-be-outputted data based on the number L of the survivor paths, the length N0 of the mother code, the extracted data, the sequence numbers of the extracted data and the number of compactly arranged pieces of data,
wherein determining (105) the L pieces of to-be-outputted data based on the number L of the survivor paths, the length N0 of the mother code, the extracted data, the sequence numbers of the extracted data and the number of compactly arranged pieces of data comprises:
in a case where the number of the compactly arranged pieces of data is greater than L, performing, by using a preset array, bitonic sorting on the compactly arranged data, and extracting L pieces of data from the compactly arranged data based on the sorted data; and
in a case where the number of the compactly arranged pieces of data is less than L, complementing the compactly arranged data with complementing data, wherein a sum of the number of pieces of the complementing data and the number of the compactly arranged pieces of data is L.

2. The method according to claim 1, wherein extracting the L pieces of data from the compactly arranged data based on the sorted data comprises:
selecting L pieces of minimum data from the compactly arranged data based on the sorted data, and determining the sequence number corresponding to each piece of data in the L pieces of data.

3. The method according to claim 1, wherein complementing the compactly arranged data with the complementing data comprises:
determining values of the complementing data, wherein the value of each piece of complementing data is a maximum value which is able to be represented by a bit width of the data being complemented.

4. The method according to any one of claims 1-3, wherein after determining (105) the L pieces of to-be-outputted data, the method further comprises:
in a case where the number of the compactly arranged pieces of data is greater than L, extracting corresponding truncated low-bit information from the memory according to information of the sequence numbers of the extracted L pieces of data, and splicing the extracted L pieces of data and the extracted low-bit information into original data; and
in a case where the number of the compactly arranged pieces of data is less than or equal to L, extracting corresponding truncated low-bit information from the memory according to information of the sequence numbers corresponding to the compactly arranged data, and splicing the compactly arranged data and the extracted low-bit information into original data.

5. A sorting apparatus, comprising:
an acquisition module (10), configured to acquire configuration information, wherein the configuration information comprises a number L of survivor paths, a length N0 of a mother code, at least one path deletion instruction and a truncation bit width W, wherein the number L corresponds to the maximum number of paths that a Successive Cancellation List, called SCL, decoding algorithm simultaneously maintains during decoding and the at least one path deletion instruction indicates which bits in a respective path correspond to information bits;
a truncation module (20), configured to perform truncation processing on each of multiple pieces of inputted data according to the truncation bit width W, wherein the inputted data is path metric, called PM, values of paths to be sorted, W lowest bits of each of the multiple pieces of inputted data are truncated from each piece of data to obtain low-bit information of the piece of data, and remaining data from which the W lowest bits have been truncated is high-bit information of the piece of data, and store, in a memory, each piece of the low-bit information;
an extraction module (30), configured to perform, according to the at least one path deletion instruction, data extraction on the multiple pieces of high-bit information, record sequence numbers of the extracted data corresponding to the order of the data before data extraction, wherein the extracted data corresponds to all information bits of a respective path, compactly arrange the extracted data to obtain compactly arranged data, and determine the number of data comprised in the compactly arranged data, wherein the extracted data is concatenated to form the compactly arranged data, and the compactly arranged data is arranged in the same order of sequence numbers as the data before data extraction; and
an output control module (40), configured to determine L pieces of to-be-outputted data based on the number L of the survivor paths, the length N0 of the mother code, the extracted data, the sequence numbers of the extracted data and the number of the compactly arranged pieces of data,
wherein the output control module (40) comprises:
a sorting module (50), configured to, in a case where the number of the compactly arranged pieces of data is greater than L, perform, by using a preset array, bitonic sorting on the compactly arranged data obtained by the extraction module (30), and extract L pieces of data from the compactly arranged data based on the sorted data; and
a complementing module (60), configured to, in a case where the number of the compactly arranged pieces of data obtained by the extraction module (30) is less than L, complement the compactly arranged data with complementing data, wherein a sum of the number of pieces of the complementing data and the number of the compactly arranged pieces of data is L.

6. The apparatus according to claim 5, wherein the sorting module (50) is configured to select L pieces of minimum data from the compactly arranged data based on the sorted data, and determine the sequence number corresponding to each piece of data in the L pieces of data.

7. The apparatus according to claim 5, wherein the complementing module (60) is configured to determine values of the complementing data, wherein the value of each piece of complementing data is a maximum value which is able to be represented by a bit width of the data being complemented.

8. The apparatus according to any one of claims 5-7, further comprising: a bit-complementing module (70), the bit-complementing module (70) being configured to:
in a case where the number of the compactly arranged pieces of data is greater than L, extract corresponding truncated low-bit information from the memory according to information of the sequence numbers of the extracted L pieces of data, and splice the extracted L pieces of data and the extracted low-bit information into original data; and
in a case where the number of the compactly arranged pieces of data is less than or equal to **L,** extract corresponding truncated low-bit information from the memory according to information of the sequence numbers corresponding to the compactly arranged data, and splice the compactly arranged data and the extracted low-bit information into original data.

9. An electronic device, comprising:
at least one processor (810); and
a memory (820) configured to store at least one computer program,
wherein when the at least one computer program is executed by the at least one processor (810), the at least one processor (810) is enabled to implement the sorting method according to any one of claims 1-4.

10. A computer readable storage medium comprising instructions which, when executed by a computer, cause the computer to carry out the sorting method of any one of claims 1-4.

## Patentansprüche

1. Verfahren zum Sortieren, umfassend:
Erfassen (101) von Konfigurationsinformationen, wobei die Konfigurationsinformationen eine Anzahl L von Survivor-Pfaden, eine Länge N0 eines Muttercodes, wenigstens eine Pfadlöschanweisung und eine Trunkierungsbitbreite W umfassen, wobei die Anzahl L der maximalen Anzahl von Pfaden entspricht, die ein Decodieralgorithmus einer sukzessiven Löschliste, der als SCL bezeichnet wird, während des Decodierens gleichzeitig beibehält, und die wenigstens eine Pfadlöschanweisung angibt, welche Bits in einem jeweiligen Pfad Informationsbits entsprechen;
Durchführen (102) von Trunkierungsverarbeitung an jedem von mehreren Stücken von eingegebenen Daten gemäß der Trunkierungsbitbreite W, wobei die eingegebenen Daten Pfadmetrikwerte, die als PM bezeichnet werden, von zu sortierenden Pfaden sind, W niedrigste Bits von jedem der mehreren Stücke von eingegebenen Daten von jedem Stück von Daten trunkiert werden, um Low-Bit-Informationen des Stücks von Daten zu erhalten, und verbleibende Daten, von denen die W niedrigsten Bits trunkiert wurden, High-Bit-Informationen des Stücks von Daten sind, und Speichern (102), in einem Speicher, jedes Stücks der Low-Bit-Informationen;
Durchführen (103), gemäß der wenigstens einen Pfadlöschanweisung, von Datenextraktion an den mehreren Stücken von High-Bit-Informationen und Aufzeichnen (103) von Sequenznummern der extrahierten Daten entsprechend der Reihenfolge der Daten vor der Datenextraktion, wobei die extrahierten Daten allen Informationsbits eines jeweiligen Pfads entsprechen;
kompaktes Anordnen (104) der extrahierten Daten, um kompakt angeordnete Daten zu erhalten, und Bestimmen der Anzahl von Daten, die in den kompakt angeordneten Daten enthalten sind, wobei die extrahierten Daten verkettet werden, um die kompakt angeordneten Daten zu bilden, und die kompakt angeordneten Daten in der gleichen Reihenfolge von Sequenznummern wie die Daten vor der Datenextraktion angeordnet werden; und
Bestimmen (105) von L Stücken von auszugebenden Daten auf der Basis der Anzahl L der Survivor-Pfade, der Länge N0 des Muttercodes, der extrahierten Daten, der Sequenznummern der extrahierten Daten und der Anzahl von kompakt angeordneten Stücken von Daten,
wobei das Bestimmen (105) der L Stücke von auszugebenden Daten auf der Basis der Anzahl L der Survivor-Pfade, der Länge N0 des Muttercodes, der extrahierten Daten, der Sequenznummern der extrahierten Daten und der Anzahl von kompakt angeordneten Stücken von Daten umfasst:
in einem Fall, in dem die Anzahl der kompakt angeordneten Stücke von Daten größer als L ist, Durchführen, durch Verwenden eines voreingestellten Arrays, von bitonem Sortieren an den kompakt angeordneten Daten und Extrahieren von L Stücken von Daten aus den kompakt angeordneten Daten auf der Basis der sortierten Daten; und
in einem Fall, in dem die Anzahl der kompakt angeordneten Stücke von Daten kleiner als L ist, Komplementieren der kompakt angeordneten Daten mit Komplementierungsdaten, wobei eine Summe der Anzahl von Stücken der Komplementierungsdaten und der Anzahl der kompakt angeordneten Stücke von Daten L ist.

2. Verfahren nach Anspruch 1, wobei das Extrahieren der L Stücke von Daten aus den kompakt angeordneten Daten auf der Basis der sortierten Daten umfasst:
Auswählen von L Stücken von Minimaldaten aus den kompakt angeordneten Daten auf der Basis der sortierten Daten und Bestimmen der Sequenznummer, die jedem Stück von Daten in den L Stücken von Daten entspricht.

3. Verfahren nach Anspruch 1, wobei das Komplementieren der kompakt angeordneten Daten mit den Komplementierungsdaten umfasst:
Bestimmen von Werten der Komplementierungsdaten, wobei der Wert jedes Stücks von Komplementierungsdaten ein maximaler Wert ist, der durch eine Bitbreite der zu komplementierenden Daten repräsentiert werden kann.

4. Verfahren nach einem der Ansprüche 1 bis 3, wobei das Verfahren nach dem Bestimmen (105) der L Stücke von auszugebenden Daten ferner umfasst:
in einem Fall, in dem die Anzahl der kompakt angeordneten Stücke von Daten größer als L ist, Extrahieren von entsprechenden trunkierten Low-Bit-Informationen aus dem Speicher gemäß Informationen der Sequenznummern der extrahierten L Stücke von Daten und Zusammenfügen der extrahierten L Stücke von Daten und der extrahierten Low-Bit-Informationen in Originaldaten; und
in einem Fall, in dem die Anzahl der kompakt angeordneten Stücke von Daten kleiner als oder gleich L ist, Extrahieren von entsprechenden trunkierten Low-Bit-Informationen aus dem Speicher gemäß Informationen der Sequenznummern, die den kompakt angeordneten Daten entsprechen, und Zusammenfügen der kompakt angeordneten Daten und der extrahierten Low-Bit-Informationen in Originaldaten.

5. Vorrichtung zum Sortieren, umfassend:
ein Erfassungsmodul (10), das zum Erfassen von Konfigurationsinformationen konfiguriert ist, wobei die Konfigurationsinformationen eine Anzahl L von Survivor-Pfaden, eine Länge N0 eines Muttercodes, wenigstens eine Pfadlöschanweisung und eine Trunkierungsbitbreite W umfassen, wobei die Anzahl L der maximalen Anzahl von Pfaden entspricht, die ein Decodieralgorithmus einer sukzessiven Löschliste, der als SCL bezeichnet wird, während des Decodierens gleichzeitig beibehält, und die wenigstens eine Pfadlöschanweisung angibt, welche Bits in einem jeweiligen Pfad Informationsbits entsprechen;
ein Trunkierungsmodul (20), das zum Durchführen von Trunkierungsverarbeitung an jedem von mehreren Stücken von eingegebenen Daten gemäß der Trunkierungsbitbreite W konfiguriert ist, wobei die eingegebenen Daten Pfadmetrikwerte, die als PM bezeichnet werden, von zu sortierenden Pfaden sind, W niedrigste Bits von jedem der mehreren Stücke von eingegebenen Daten von jedem Stück von Daten trunkiert werden, um Low-Bit-Informationen des Stücks von Daten zu erhalten, und verbleibende Daten, von denen die W niedrigsten Bits trunkiert wurden, High-Bit-Informationen des Stücks von Daten sind, und Speichern, in einem Speicher, jedes Stücks der Low-Bit-Informationen;
ein Extraktionsmodul (30), das zum Durchführen, gemäß der wenigstens einen Pfadlöschanweisung, von Datenextraktion an den mehreren Stücken von High-Bit-Informationen, Aufzeichnen von Sequenznummern der extrahierten Daten entsprechend der Reihenfolge der Daten vor der Datenextraktion, wobei die extrahierten Daten allen Informationsbits eines jeweiligen Pfads entsprechen, kompakten Anordnen der extrahierten Daten, um kompakt angeordnete Daten zu erhalten, und Bestimmen der Anzahl von Daten, die in den kompakt angeordneten Daten enthalten sind, konfiguriert ist, wobei die extrahierten Daten verkettet werden, um die kompakt angeordneten Daten zu bilden, und die kompakt angeordneten Daten in der gleichen Reihenfolge von Sequenznummern wie die Daten vor der Datenextraktion angeordnet werden; und
ein Ausgabe-Steuerungsmodul (40), das zum Bestimmen von L Stücken von auszugebenden Daten auf der Basis der Anzahl L der Survivor-Pfade, der Länge N0 des Muttercodes, der extrahierten Daten, der Sequenznummern der extrahierten Daten und der Anzahl der kompakt angeordneten Stücke von Daten konfiguriert ist,
wobei das Ausgabe-Steuerungsmodul (40) umfasst:
ein Sortiermodul (50), das zum Durchführen, in einem Fall, in dem die Anzahl der kompakt angeordneten Stücke von Daten größer als L ist, durch Verwenden eines voreingestellten Arrays, von bitonem Sortieren an den kompakt angeordneten Daten, die durch das Extraktionsmodul (30) erhalten werden, und Extrahieren von L Stücken von Daten aus den kompakt angeordneten Daten auf der Basis der sortierten Daten konfiguriert ist; und
ein Komplementierungsmodul (60), das zum Komplementieren, in einem Fall, in dem die Anzahl der kompakt angeordneten Stücke von Daten, die durch das Extraktionsmodul (30) erhalten werden, kleiner als L ist, der kompakt angeordneten Daten mit Komplementierungsdaten konfiguriert ist, wobei eine Summe der Anzahl von Stücken der Komplementierungsdaten und der Anzahl der kompakt angeordneten Stücke von Daten L ist.

6. Vorrichtung nach Anspruch 5, wobei das Sortiermodul (50) zum Auswählen von L Stücken von Minimaldaten aus den kompakt angeordneten Daten auf der Basis der sortierten Daten und Bestimmen der Sequenznummer, die jedem Stück von Daten in den L Stücken von Daten entspricht, konfiguriert ist.

7. Vorrichtung nach Anspruch 5, wobei das Komplementierungsmodul (60) zum Bestimmen von Werten der Komplementierungsdaten konfiguriert ist, wobei der Wert jedes Stücks von Komplementierungsdaten ein maximaler Wert ist, der durch eine Bitbreite der zu komplementierenden Daten repräsentiert werden kann.

8. Vorrichtung nach einem der Ansprüche 5-7, ferner umfassend: ein Bit-Komplementierungsmodul (70), wobei das Bit-Komplementierungsmodul (70) konfiguriert ist zum:
in einem Fall, in dem die Anzahl der kompakt angeordneten Stücke von Daten größer als L ist, Extrahieren von entsprechenden trunkierten Low-Bit-Informationen aus dem Speicher gemäß Informationen der Sequenznummern der extrahierten L Stücke von Daten und Zusammenfügen der extrahierten L Stücke von Daten und der extrahierten Low-Bit-Informationen in Originaldaten; und
in einem Fall, in dem die Anzahl der kompakt angeordneten Stücke von Daten kleiner als oder gleich L ist, Extrahieren von entsprechenden trunkierten Low-Bit-Informationen aus dem Speicher gemäß Informationen der Sequenznummern, die den kompakt angeordneten Daten entsprechen, und Zusammenfügen der kompakt angeordneten Daten und der extrahierten Low-Bit-Informationen in Originaldaten.

9. Elektronisches Gerät, umfassend:
mindestens einen Prozessor (810); und
einen Speicher (820), der zum Speichern mindestens eines Computerprogramms konfiguriert ist,
wobei, wenn das mindestens eine Computerprogramm von dem mindestens einen Prozessor (810) ausgeführt wird, der mindestens eine Prozessor (810) zum Implementieren des Verfahrens zum Sortieren nach einem der Ansprüche 1-4 aktiviert wird.

10. Computerlesbares Speichermedium, umfassend Anweisungen, die, wenn sie von einem Computer ausgeführt werden, den Computer zum Ausführen des Verfahrens zum Sortieren nach einem der Ansprüche 1-4 veranlassen.

## Revendications

1. Procédé de triage, comprenant les étapes consistant à :
acquérir (101) des informations de configuration, dans lequel les informations de configuration comprennent un nombre L de trajets survivants, une longueur N0 d'un code-mère, au moins une instruction d'élimination de trajet et une largeur binaire de troncature W, dans lequel le nombre L correspond au nombre maximum de trajets qu'un algorithme de décodage de liste d'annulation successive, appelée SCL, maintient simultanément pendant le décodage et l'au moins une instruction d'élimination de trajet indique quels bits dans un trajet respectif correspondent à des bits d'informations ;
réaliser (102) un traitement de troncature sur chacun de multiples éléments de données entrées en fonction de la largeur binaire de troncature W, dans lequel les données entrées sont des valeurs métriques de trajet, appelées PM, de trajets à trier, les W bits les plus faibles de chacun des multiples éléments de données entrées sont tronqués à partir de chaque élément de données pour obtenir des informations de bits faibles de l'élément de données, et les données restantes à partir desquelles les W bits les plus faibles ont été tronqués sont des informations de bits élevés de l'élément de données, et stocker (102), dans une mémoire, chaque élément des informations de bits faibles ;
réaliser (103), en fonction de l'au moins une instruction d'élimination de trajet, une extraction de données sur les multiples éléments d'informations de bits élevés, et enregistrer (103) des numéros de séquence des données extraites correspondant à l'ordre des données avant l'extraction de données, dans lequel les données extraites correspondent à tous les bits d'informations d'un trajet respectif ;
agencer de manière compacte (104) les données extraites pour obtenir des données agencées de manière compacte, et déterminer le nombre de données comprises dans les données agencées de manière compacte, dans lequel les données extraites sont concaténées pour former les données agencées de manière compacte, et les données agencées de manière compacte sont agencées dans le même ordre de numéros de séquence que les données avant l'extraction de données ; et
déterminer (105) L éléments de données à délivrer en sortie sur la base du nombre L des trajets survivants, de la longueur N0 du code-mère, des données extraites, des numéros de séquence des données extraites et du nombre d'éléments de données agencés de manière compacte,
dans lequel déterminer (105) les L éléments de données à délivrer en sortie sur la base du nombre L des trajets survivants, de la longueur N0 du code-mère, des données extraites, des numéros de séquence des données extraites et du nombre d'éléments de données agencés de manière compacte comprend les étapes consistant à :
dans un cas où le nombre d'éléments de données agencés de manière compacte est supérieur à L, réaliser, en utilisant un réseau prédéfini, un triage bitone sur les données agencées de manière compacte, et extraire L éléments de données à partir des données agencées de manière compacte sur la base des données triées ; et
dans un cas où le nombre d'éléments de données agencés de manière compacte est inférieur à L, compléter les données agencées de manière compacte avec des données de complémentation, dans lequel une somme du nombre d'éléments des données de complémentation et du nombre d'éléments de données agencés de manière compacte est L.

2. Procédé selon la revendication 1, dans lequel extraire les L éléments de données à partir des données agencées de manière compacte sur la base des données triées comprend les étapes consistant à :
sélectionner L éléments de données minimum à partir des données agencées de manière compacte sur la base des données triées, et déterminer le numéro de séquence correspondant à chaque élément de données dans les L éléments de données.

3. Procédé selon la revendication 1, dans lequel compléter les données agencées de manière compacte avec les données de complémentation comprend les étapes consistant à :
déterminer des valeurs des données de complémentation, dans lequel la valeur de chaque élément de données de complémentation est une valeur maximum qui peut être représentée par une largeur binaire des données qui sont complétées.

4. Procédé selon l'une quelconque des revendications 1 à 3, dans lequel après avoir déterminé (105) les L éléments de données à délivrer en sortie, le procédé comprend en outre les étapes consistant à :
dans un cas où le nombre d'éléments de données agencés de manière compacte est supérieur à L, extraire des informations de bits faibles tronquées correspondantes à partir de la mémoire en fonction d'informations des numéros de séquence des L éléments de données extraits, et assembler les L éléments de données extraits et les informations de bits faibles extraites en données d'origine ; et
dans un cas où le nombre d'éléments de données agencés de manière compacte est inférieur ou égal à L, extraire des informations de bits faibles tronquées correspondantes à partir de la mémoire en fonction d'informations des numéros de séquence correspondant aux données agencées de manière compacte, et assembler les données agencées de manière compacte et les informations de bits faibles extraites en données d'origine.

5. Appareil de triage, comprenant :
un module d'acquisition (10), configuré pour acquérir des informations de configuration, dans lequel les informations de configuration comprennent un nombre L de trajets survivants, une longueur N0 d'un code-mère, au moins une instruction d'élimination de trajet et une largeur binaire de troncature W, dans lequel le nombre L correspond au nombre maximum de trajets qu'un algorithme de décodage de liste d'annulation successive, appelée SCL, maintient simultanément pendant le décodage et l'au moins une instruction d'élimination de trajet indique quels bits dans un trajet respectif correspondent à des bits d'informations ;
un module de troncature (20), configuré pour réaliser un traitement de troncature sur chacun de multiples éléments de données entrées en fonction de la largeur binaire de troncature W, dans lequel les données entrées sont des valeurs métriques de trajet, appelées PM, de trajets à trier, les W bits les plus faibles de chacun des multiples éléments de données entrées sont tronqués à partir de chaque élément de données pour obtenir des informations de bits faibles de l'élément de données, et les données restantes à partir desquelles les W bits les plus faibles ont été tronqués sont des informations de bits élevés de l'élément de données, et stocker, dans une mémoire, chaque élément des informations de bits faibles ;
un module d'extraction (30), configuré pour réaliser, en fonction de l'au moins une instruction d'élimination de trajet, une extraction de données sur les multiples éléments d'informations de bits élevés, enregistrer des numéros de séquence des données extraites correspondant à l'ordre des données avant l'extraction de données, dans lequel les données extraites correspondent à tous les bits d'informations d'un trajet respectif, agencer de manière compacte les données extraites pour obtenir des données agencées de manière compacte, et déterminer le nombre de données comprises dans les données agencées de manière compacte, dans lequel les données extraites sont concaténées pour former les données agencées de manière compacte, et les données agencées de manière compacte sont agencées dans le même ordre de numéros de séquence que les données avant l'extraction de données ; et
un module de contrôle de sortie (40), configuré pour déterminer L éléments de données à délivrer en sortie sur la base du nombre L des trajets survivants, de la longueur N0 du code-mère, des données extraites, des numéros de séquence des données extraites et du nombre d'éléments de données agencés de manière compacte,
dans lequel le module de contrôle de sortie (40) comprend :
un module de triage (50), configuré pour, dans un cas où le nombre d'éléments de données agencés de manière compacte est supérieur à L, réaliser, en utilisant un réseau prédéfini, un triage bitone sur les données agencées de manière compacte obtenues par le module d'extraction (30), et extraire L éléments de données à partir des données agencées de manière compacte sur la base des données triées ; et
un module de complémentation (60), configuré pour, dans un cas où le nombre d'éléments de données agencés de manière compacte obtenus par le module d'extraction (30) est inférieur à L, compléter les données agencées de manière compacte avec des données de complémentation, dans lequel une somme du nombre d'éléments des données de complémentation et du nombre d'éléments de données agencés de manière compacte est L.

6. Appareil selon la revendication 5, dans lequel le module de triage (50) est configuré pour sélectionner L éléments de données minimum à partir des données agencées de manière compacte sur la base des données triées, et déterminer le numéro de séquence correspondant à chaque élément de données dans les L éléments de données.

7. Appareil selon la revendication 5, dans lequel le module de complémentation (60) est configuré pour déterminer des valeurs des données de complémentation, dans lequel la valeur de chaque élément de données de complémentation est une valeur maximum qui peut être représentée par une largeur binaire des données qui sont complétées.

8. Appareil selon l'une quelconque des revendications 5 à 7, comprenant en outre : un module de complémentation binaire (70), le module de complémentation binaire (70) étant configuré pour :
dans un cas où le nombre d'éléments de données agencés de manière compacte est supérieur à L, extraire des informations de bits faibles tronquées correspondantes à partir de la mémoire en fonction d'informations des numéros de séquence des L éléments de données extraits, et assembler les L éléments de données extraits et les informations de bits faibles extraites en données d'origine ; et
dans un cas où le nombre d'éléments de données agencés de manière compacte est inférieur ou égal à L, extraire des informations de bits faibles tronquées correspondantes à partir de la mémoire en fonction d'informations des numéros de séquence correspondant aux données agencées de manière compacte, et assembler les données agencées de manière compacte et les informations de bits faibles extraites en données d'origine.

9. Dispositif électronique, comprenant :
au moins un processeur (810) ; et
une mémoire (820) configurée pour stocker au moins un programme informatique,
dans lequel lorsque l'au moins un programme informatique est exécuté par l'au moins un processeur (810), l'au moins un processeur (810) est activé pour mettre en œuvre le procédé de triage selon l'une quelconque des revendications 1 à 4.

10. Moyen de stockage lisible par ordinateur comprenant des instructions qui, lorsqu'elles sont exécutées par un ordinateur, amènent l'ordinateur à réaliser le procédé de triage selon l'une quelconque des revendications 1 à 4.
